(19) Europäisches Patentamt
European Patent Office
Office européen des brevets

(11) **EP 1 641 132 B1**

(12) **EUROPEAN PATENT SPECIFICATION**

(45) Date of publication and mention
of the grant of the patent:
**20.06.2007 Bulletin 2007/25**

(51) Int Cl.:
***H04B 1/04*** (2006.01)

(21) Application number: **04360087.3**

(22) Date of filing: **24.09.2004**

(54) **transmitter and transmission method**

Sender und Übertragungsverfahren

Emetteur et procédé de transmission

(84) Designated Contracting States:
**AT BE BG CH CY CZ DE DK EE ES FI FR GB GR
HU IE IT LI LU MC NL PL PT RO SE SI SK TR**

(43) Date of publication of application:
**29.03.2006 Bulletin 2006/13**

(73) Proprietor: **Alcatel Lucent
75008 Paris (FR)**

(72) Inventors:
• **Windisch, Marcus
01187 Dresden (DE)**

• **Weiss, Ulrich, Dipl.-Ing.
73035 Göppingen (DE)**

(74) Representative: **Knecht, Ulrich Karl
Alcatel Lucent
Intellectual Property & Standards
70430 Stuttgart (DE)**

(56) References cited:
**WO-A-03/043206          US-B1- 6 658 065**

**Description**

**Field of the invention.**

The present invention relates to the field of telecommunication, and more particularly to advanced transmitter architectures based on I/Q signal processing.

**Background and prior art**

The rejection of the image signal is a problem inherent to all receiver architectures. One of the benefits of a low-IF receiver is, that image rejection is realized by I/Q signal processing instead of a fixed analog filter, making it highly reconfigurable and cost-efficient. However, unavoidable imbalances between the I and Q- branch leads to a limited image attenuation.

M. Windisch and G. Fettweis, "Blind I/Q Imbalance Parameter Estimation and Compensation in Low-IF Receivers," in Proceedings of the 1st International Symposium on Control, Communications and Signal Processing (ISCCSP 2004), (Hammamet, Tunisia), 21-24 Mar. 2004 shows an I/Q imbalance compensation scheme, in which the unknown analog imbalance parameters are estimated digitally without a need for any calibration or training signal. Based on these estimates the interference by the image signal is effectively compensated, upgrading the vulnerable ordinary low-IF receiver to a powerful advanced receiver architecture, where the mean value of the image-to-signal-ratio never exceeds a pre-defined maximum value, regardless of the image signal power. Because the I/Q imbalances occur before the digital part of the receiver, a straight-forward compensation technique based on adaptive filtering or blind parameter estimation can be realized.

The situation is much more difficult for transmitter I/Q imbalance. Because here the analog I/Q imbalance occurs after the digital part of the transmitter, a digital post-correction is feasible at the receiver side only (cf. L. Brötje, S. Vogeler, and K.-D. Kammeyer, "Estimation and Correction of transmitter-caused I/Q Imbalance in OFDM Systems," in Proceedings of the 7th International OFDM-Workshop, 10-11 Sept. 2002. and X. Huang, "On Transmitter Gain/Phase Imbalance Compensation At Receiver," IEEE Communications Letters, vol. 4, pp. 363-365, Nov. 2000). However, such approaches often assume no I/Q imbalance at the receiver and/or a non-frequency selective channel, which restricts their suitability in practise.

Alternatively, the I/Q imbalance compensation can be realized in the digital part of the transmitter in terms of a digital pre-distortion. A proper calibration of the pre-distortion block with respect to the subsequent unknown I/Q imbalance is challenging. All previously published calibration techniques are performed offline using dedicated calibration signals (cf. J. K. Cavers and M. W. Liao, "Adaptive Compensation for Imbalance and Offset Losses in Direct Conversion Transceivers," IEEE Transactions on Vehicular Technology, vol. 42, pp. 581-588, Nov. 1993 and X. Huang and M. Caron, "Gain/phase imbalance and DC offset compensation in quadrature modulators," in IEEE International Symposium on Circuits and Systems 2002, vol. 4, pp. IV-811-IV-814, 26-29 May 2002). However, offline calibration requires an interrupt of the regular transmission mode. Furthermore, the signal path to the antenna has to be disconnected during calibration in order to prevent the calibration signal from being radiated.

WO 03/043206 A2 relates to an emission device, especially for mobile telephony, comprising a quadrature modulator and a compensation path for compensating the modulator in terms of the suppression of the vestigial sideband and the carrier. To this end, compensation means are controlled according to intermodulation products which are generated at the output of a non-linear component which is connected to the output of the quadrature modulator, in such a way that fractions of the first frequency of the input signal of the quadrature modulator or fractions of the double first frequency are minimised. To this end, the compensation means comprise means for influencing the identical fraction of the signal in addition to the amplitude and phase position of the signal.

The ever growing number of wireless communications standards calls for highly reconfigurable transmitter architectures. Advanced transmitters must be able to support a broad range of radio frequency (RF) parameters, such as carrier frequency and bandwidth. There is therefore a need for an improved transmitter that facilitates the implementation of such wireless communication standards.

**Summary of the invention**

In accordance with the present invention, a transmitter is provided that has means for generating an intermediate frequency (IF) signal, means for predistortion of the IF signal using a predistortion parameter, means for generating a radio frequency (RF) signal from the predistorted (IF) signal, means for measuring an image-to-signal-ratio (ISR) of the RF signal, and means for adaptation of the predistortion parameter for reduction of the ISR.

The present invention is particularly advantageous as it enables on-line calibration of the predistortion parameters using the regular transmit signal only. For example, the ISR is defined as the amplitude or power ratio of the image signal and the desired signal.

The present invention can be used for uplink and/or for downlink transmitters. For example, the invention can be implemented in a base station of a cellular communication network or in a mobile terminal, such as a mobile phone.

In accordance with an embodiment of the invention the adaptation of the predistortion parameters is performed using an iterative algorithm. Preferably a cost function is used for the iterative procedure. The iterations serve to provide increasingly accurate estimates of the predistortion parameters and increasingly accurate approximations of the cost function.

In accordance with an embodiment of the invention a feedback path from an RF part of the transmitter is realized on the basis of a heterodyne receiver architecture. The frequency of the analog down-mixing local oscillator and the frequency of the additional digital local oscillator is adjusted to the frequency of the transmit local oscillator. The power estimates for determining the ISR can be obtained using time averages of the corresponding baseband signals.

In accordance with an embodiment of the invention the current ISR is compared with a threshold ISR. For example, the threshold ISR is defined in a wireless communication standard that is to be implemented by the transmitter. When the current ISR is below the target ISR, no further adaptation of the predistortion parameters is performed until the current ISR increases above the target ISR. For example the target ISR is chosen to be in compliance with the applicable standard.

### Brief description of the drawings

In the following preferred embodiments of the invention are described in greater detail, by way of example only, making reference to the drawings in which:

Figure 1   is a block diagram of a preferred embodiment of a transmitter,

Figure 2   schematically shows the spectra of the baseband signal, IF signal, RF signal and the ISR,

Figure 3   is a flowchart illustrating a preferred mode of operation of the transmitter of figure 1,

Figure 4   shows a circuit for compensating undesirable cross-talk,

Figure 5   shows a circuit for compensating the undesirable cross-talk using a single imbalance model,

Figure 6   shows a table of predistortion parameters,

Figure 7   shows an example for estimation errors and ISR,

Figure 8   shows the ISR for randomly generated I/Q imbalance parameters,

Figure 9   shows a block diagram of an embodiment of the transmitter including a heterodyne receiver based feedback loop for estimating the power of the desired signal and image signal,

Figure 10   shows the performance degradation of the adaptation due to an imperfect measurement of the ISR.

### Detailed description

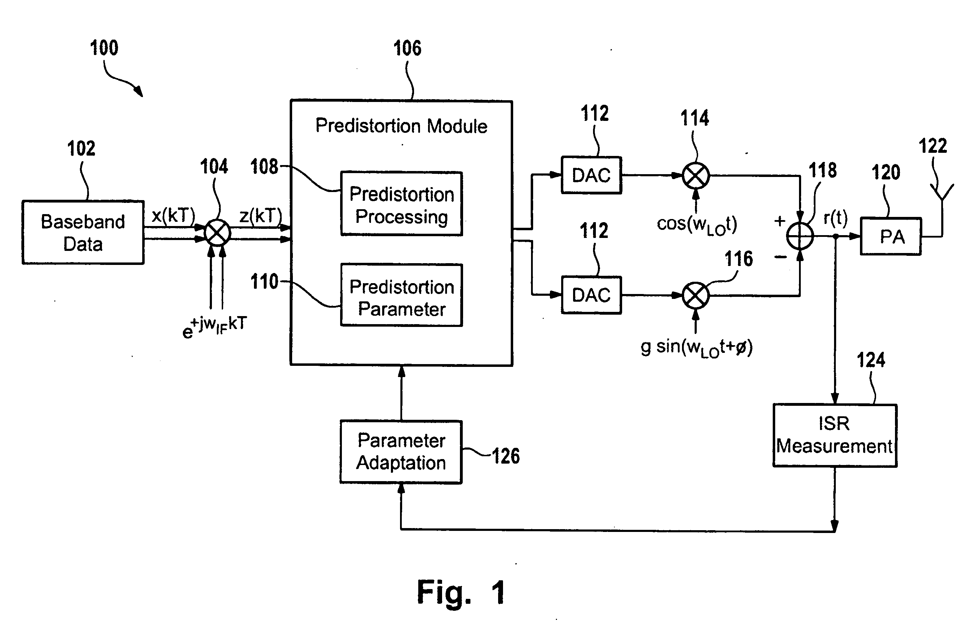

Figure 1 shows a transmitter 100. The transmitter 100 has a digital-IF architecture. The upconversion of the transmit signal 102 from baseband to the RF carrier frequency is realized by a tuneable digital I/Q upconversion and a subsequent tuneable or fixed analog I/Q upconversion.

Perfectly balanced I/Q mixing (equal gain in the I- and in the Q- branch, exactly 90˚ phase shift between both phases of the oscillator) would lead to an infinite rejection of the image signal such that no costly image rejection filter would be required. However, due to hardware tolerances a perfectly balanced analog I/Q mixer is not feasible, resulting in a limited suppression of the image signal. A radiation of the unwanted residual image is critical, since the compliance with the spectral mask of the desired communication standard might be violated.

Therefore the effects of I/Q imbalance are compensated by using digital signal processing.

The transmitter 100 has a digital mixer 104. The digital mixer 104 serves to generate an IF signal z from the baseband signal x. The IF signal z is received by a predistortion module 106. The predistortion module 106 has a predistortion processing component 108 for processing the IF signal z in order to compensate for hardware tolerances that cause the image signal. The predistortion module 106 has a storage 110 for storage of one or more predistortion parameters that are used by the predistortion processing component 108 in order to perform the predistortion processing of the IF signal z.

The IF signal z is converted from digital to analog by the digital to analog converters 112. The I and Q components of the IF signal z are upconverted by multipliers 114 and 116, respectively. The upconverted I and Q components of the IF signal z are substracted by substractor 118 and the resultant radio frequency (RF) signal r is amplified by means of the power amplifier (PA) 120. The power amplifier 120 is coupled to an antenna 122 for sending of the power amplified RF signal r.

The transmitter 100 has an image-to-signal-power-ratio (ISR) measurement component 124 for determining or estimating an ISR of the RF signal r. The ISR measurement component 124 provides the ISR to a parameter adaptation component 126 of the transmitter 100. The parameter adaptation component 126 implements an algorithm for calibrating the predistortion parameter(s) for reduction of the ISR. The adapted predistortion parameter(s) are provided from the parameter adaptation component 126 to the storage 110 for use by the predistortion processing component 108.

In the following the digital baseband signal $x(kT)$ is considered as an exemplary transmit signal 102. A perfectly balanced I/Q mixing is feasible digitally, resulting in the digital IF (intermediate frequency) signal $z(kT) = x(kT)e^{+j\omega_{IF}kT}$. $\omega_{IF}$ denotes the (angular) frequency of the digital mixer. After D/A conversion the continuous-time IF signal $z(t)$ is multiplied with an imbalanced analog local oscillator (LO) with the time function $Y_{LO}(t) = \cos(\omega_{LO}t) + jg\sin(\omega_{LO}t + \phi)$, where $g$ denotes gain imbalance, $\phi$ denotes phase imbalance, and $\omega_{LO}$ denotes the LO (angular) frequency. A perfect matching of the analog mixer corresponds to $g = 1, \phi = 0$. For the purpose of a convenient analysis we further define the equivalent imbalance parameters $\alpha = g\cos\phi, \beta = g\sin\phi$, and

$$(1)$$

$$K_1 = \frac{1}{2}(1 + ge^{+j\phi}) = \frac{1}{2}(1 + \alpha + j\beta),$$

$$K_2 = \frac{1}{2}(1 - ge^{-j\phi}) = \frac{1}{2}(1 - \alpha + j\beta).$$

A perfect matching of the analog mixer corresponds to $\alpha = 1, \beta = 0$, or equivalently $K_1 = 1, K_2 = 0$. With these definitions the transmitted RF signal can be written as

$$(2)$$

$$
\begin{aligned}
r(t) \quad &= \Re\{z(t)Y_{LO}(t)\} \\
&= \Re\left\{\left[x(t)e^{+j\omega_{IF}t}\right]\left[K_1e^{+j\omega_{LO}t} + K_2e^{-j\omega_{LO}t}\right]\right\} \\
&= \Re\left\{\underbrace{K_1 x(t)e^{j(\omega_{LO}+\omega_{IF})t}}_{Desired\ signal} + \underbrace{K_2^* x^*(t)e^{j(\omega_{LO}-\omega_{IF})t}}_{Image\ signal}\right\}
\end{aligned}
$$

where $x(t)$ denotes the continuous-time representation of the digital baseband signal $x(kT)$. Hence the RF signal consists of the desired transmit signal with the (angular) carrier frequency $\omega_{LO} + \omega_{IF}$, plus the unwanted image signal with the (angular) carrier frequency $\omega_{LO} - \omega_{IF}$. Each signal component is weighted by the I/Q imbalance parameters $K_1$ and $K_2$, respectively. The power of the desired signal at RF yields $P_s = |K_1|^2 P_x$ and the power of the image signal yields $P_i = |K_2|^2 P_x$, where $P_x$ denotes the power of $x(t)$. Hence the *Image-to-Signal-Power-Ratio*

$$(3)$$

$$ISR = \frac{P_i}{P_s} = \frac{|K_2|^2}{|K_1|^2}$$

is determined by the I/Q imbalance parameters only; it is independent from the transmit power $P_x$ itself.

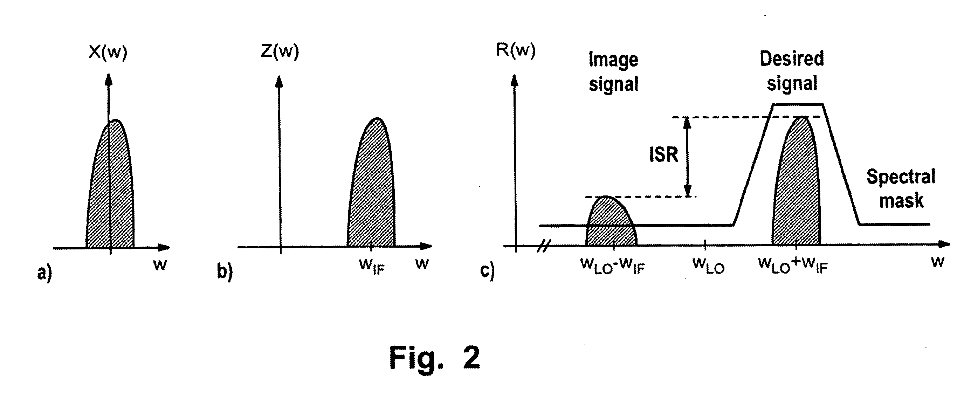

Even for small I/Q imbalances in the order of $g = 1.02$, $\phi = 2°$ the resulting *ISR* can easily reach -35 dB and above. However, in many communications standards the allowed out of band emission (described by s spectral mask, see Fig. 2) is much lower. For example, the compliance with the 3GPP UMTS standard requires an *ISR* of less than -50 dB, which cannot be fulfilled without additional I/Q imbalance compensation.

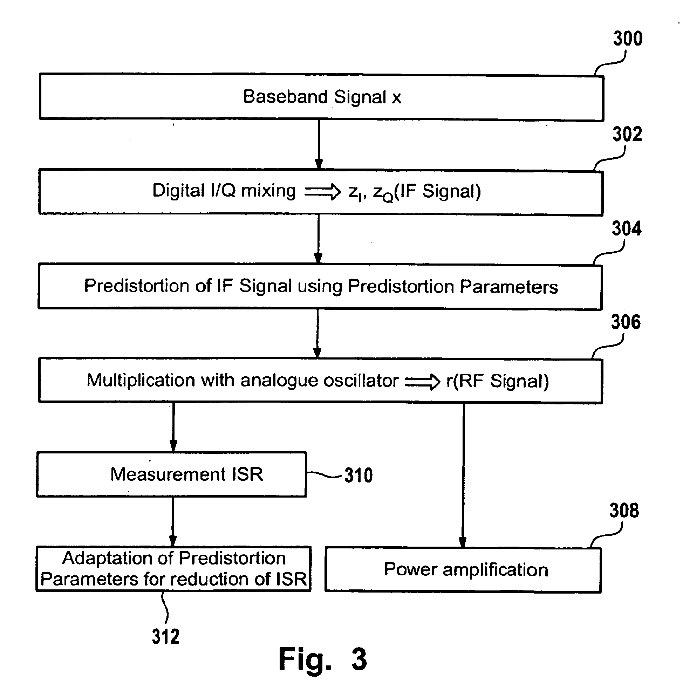

Figure 3 shows a preferred mode of operation of the transmitter 100 of figure 1 including predistortion processing and parameter adaptation for reduction of the ISR. In step 300 the baseband signal x is provided. The baseband signal x is digitally I/Q mixed to provide the IF signal z. In step 304 the IF signal z is processed in order to predistort the IF signal z using one of more predistortion parameters for reduction of the ISR of the RF signal r.

The resultant predistorted IF signal z is multiplied by means of an analog oscillator to provide the RF signal r (step 306). The RF signal r is power amplified in step 308. In parallel, the ISR of the RF signal r is measured or estimated. The current ISR is used in step 312 for adaptation of the predistortion parameters for reduction of the ISR. If the current ISR is already below a threshold or target ISR such further adaptation is not necessary.

The I/Q imbalance compensation approach considered here is based on a digital pre-distortion. In order to derive an exemplary embodiment for implementation of the pre-distortion processing, it is convenient to transform the RF I/Q Imbalance model into an equivalent IF model. Therefore above equation (2) is written using the I-and Q-component of the IF signal $z(t) = z_1(t) + jz_Q(t)$ :

$$(4)$$

$$
\begin{aligned}
r(t) \quad &= \Re e\left\{\left[z_I(t) + jz_Q(t)\right] Y_{LO}(t)\right\} \\
&= z_I(t)\cos(\omega_{LO}t) - z_Q(t)g\sin(\omega_{LO}t + \phi) \\
&= \left[z_I(t) - \beta z_Q(t)\right]\cos(\omega_{LO}t) - \alpha z_Q(t)\sin(\omega_{LO}t)
\end{aligned}
$$

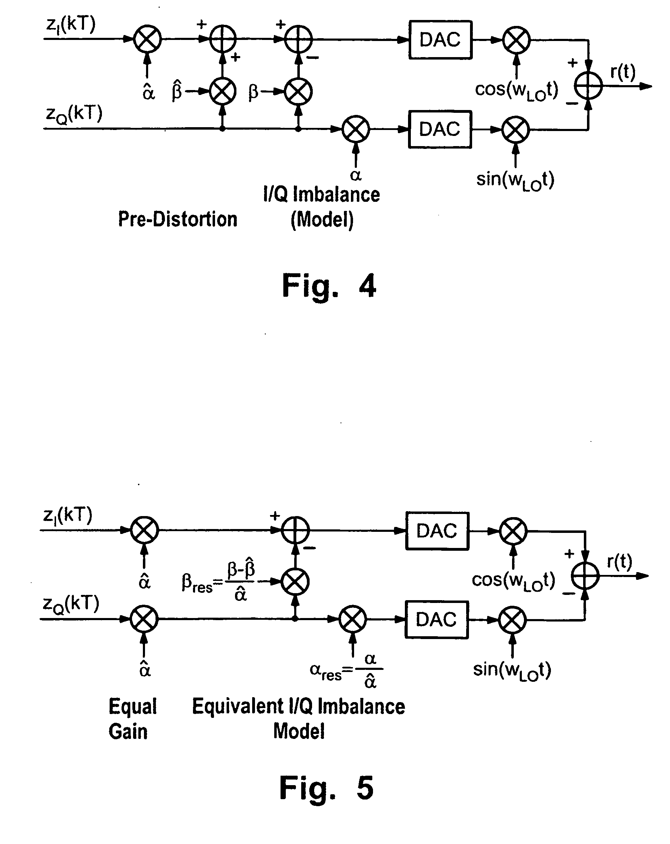

Hence the I/Q imbalance in the analog mixer can be equivalently modelled as a cross-talk between the I-and the Q-phase of the IF-signal $z(kT)$, followed by a perfect I/Q-upconversion. A straight-forward solution for compensating this undesirable cross-talk is shown in Fig. 4. Perfect compensation can be achieved, if the parameters of the pre-distortion are equal to the real I/Q imbalance parameters ($\hat{\alpha} = \alpha$, $\hat{\beta} = \beta$).

If $\alpha$ and $\beta$ are unknown, they have to be estimated. It is beneficial to perform the parameter estimation and the associated I/Q imbalance compensation blindly during regular operation of the transmitter as this avoids a need to feed the transmitter 100 with a dedicated training or calibration signal.

The idea is to view the joint system of pre-distortion and real I/Q imbalance as a black-box with unknown parameters $\alpha, \beta$ inside. The input of the black-box is fed with known compensation parameters $\hat{\alpha}$, $\hat{\beta}$ resulting in an observable *ISR* at the output. By repeated reconfiguration of the pre-distortion a solution is found that leads to a sufficiently low *ISR* at the output.

Therefore it is necessary to understand the combined effect of a (possibly not perfect adjusted) pre-distortion together with the real I/Q imbalance. Using basic transformations the system can be rewritten as shown in Fig. 5. This means, the whole system is equivalently represented by one (virtual) I/Q imbalance model with the resulting imbalance parameters

$$\alpha_{res} = \frac{\alpha}{\hat{\alpha}}, \qquad \beta_{res} = \frac{\beta - \hat{\beta}}{\hat{\alpha}}. \qquad\qquad (5)$$

In the case of a perfect estimation $\hat{\alpha} = \alpha$ and $\hat{\beta} = \beta$, the resulting equivalent I/Q imbalance vanishes completely ($\alpha_{res} = 1$, $\beta_{res} = 0$). The residual gain $\hat{\alpha}$ is not critical, since it is applied to both I-and Q-branch.

Because of the added pre-compensation structure, (1) has to be replaced by the resulting imbalance parameters

$$(6)$$

$$K_{1,res} = \frac{1}{2}(1 + \alpha_{res} + j\beta_{res}),$$

$$K_{2,res} = \frac{1}{2}(1 - \alpha_{res} + j\beta_{res}).$$

Now the power ratio yields

$$(7)$$

$$ISR = \frac{P_i}{P_s} = \frac{|K_{2,res}|^2}{|K_{1,res}|^2} = \frac{(1 - \alpha_{res})^2 + \beta_{res}^2}{(1 + \alpha_{res})^2 + \beta_{res}^2},$$

which simplifies by using (5) to

$$(8)$$

$$ISR = \frac{(\hat{\alpha} - \alpha)^2 + (\hat{\beta} - \beta)^2}{(\hat{\alpha} + \alpha)^2 + (\hat{\beta} - \beta)^2}.$$

Ideally, the configuration of the pre-distortion is such that the resulting *ISR* is zero. This corresponds to finding the minimum of the numerator in (8). Therefore the following cost function

$$(9)$$

$$J(\hat{\alpha}, \hat{\beta}) = (\hat{\alpha} - \alpha)^2 + (\hat{\beta} - \beta)^2,$$

is defined which needs to be minimized. One value of this cost function alone does not provide sufficient information about the unknown I/Q imbalance parameters. However, suppose two values $J(\hat{\alpha}_n, \hat{\beta}_m)$ and $J(\hat{\alpha}_{n-1}, \hat{\beta}_m)$ are known, which where gained using two *different* settings of $\hat{\alpha}$, but two *identical* settings of $\beta$. Then

$$(10)$$

$$J(\hat{\alpha}_n, \hat{\beta}_m) - J(\hat{\alpha}_{n-1}, \hat{\beta}_m) = \hat{\alpha}_n^2 - \hat{\alpha}_{n-1}^2 - 2(\hat{\alpha}_n - \hat{\alpha}_{n-1})\alpha$$

holds, which can be transformed into

$$(11)$$

$$\alpha = \frac{1}{2}\left[\hat{\alpha}_n + \hat{\alpha}_{n-1} - \frac{J(\hat{\alpha}_n, \hat{\beta}_m) - J(\hat{\alpha}_{n-1}, \hat{\beta}_m)}{\hat{\alpha}_n - \hat{\alpha}_{n-1}}\right].$$

Likewise, a determination of β is possible using two values of the cost function gained with two identical settings of $\hat{\alpha}$, but two different settings of $\hat{\beta}$:

$$(12)$$

$$\beta = \frac{1}{2}\left[\hat{\beta}_m + \hat{\beta}_{m-1} - \frac{J(\hat{\alpha}_n, \hat{\beta}_m) - J(\hat{\alpha}_n, \hat{\beta}_{m-1})}{\hat{\beta}_m - \hat{\beta}_{m-1}}\right].$$

These two equations would solve the black-box problem completely. Unfortunately, the cost function $J(\hat{\alpha}, \hat{\beta})$ cannot be measured directly. However, there is a close relationship between the measurable *ISR* at the output of the black-box and the cost function to be minimized. For realistic I/Q imbalances ($\alpha \approx 1, \beta \approx 0$) and sufficiently accurate estimates ($\hat{\alpha} \approx \alpha, \hat{\beta} \approx \beta$), (8) can be approximated as

$$(13)$$

$$ISR(\hat{\alpha}, \hat{\beta}) \approx \frac{1}{4\hat{\alpha}^2}\left[(\hat{\alpha} - \alpha)^2 + (\hat{\beta} - \beta)^2\right] = \frac{1}{4\hat{\alpha}^2} J(\hat{\alpha}, \hat{\beta}),$$

which justifies the definition of the approximated cost function

$$(14)$$

$$\tilde{J}(\hat{\alpha}, \hat{\beta}) = 4\hat{\alpha}^2 ISR(\hat{\alpha}, \hat{\beta})$$

A consequence of this approximation is, that a direct determination of α and β is not possible anymore. Instead, an iterative parameter estimation algorithm can be formulated, which is based on increasingly accurate estimates $\hat{\alpha}, \hat{\beta}$ on the one hand and an increasingly accurate approximation of the cost function on the other hand.

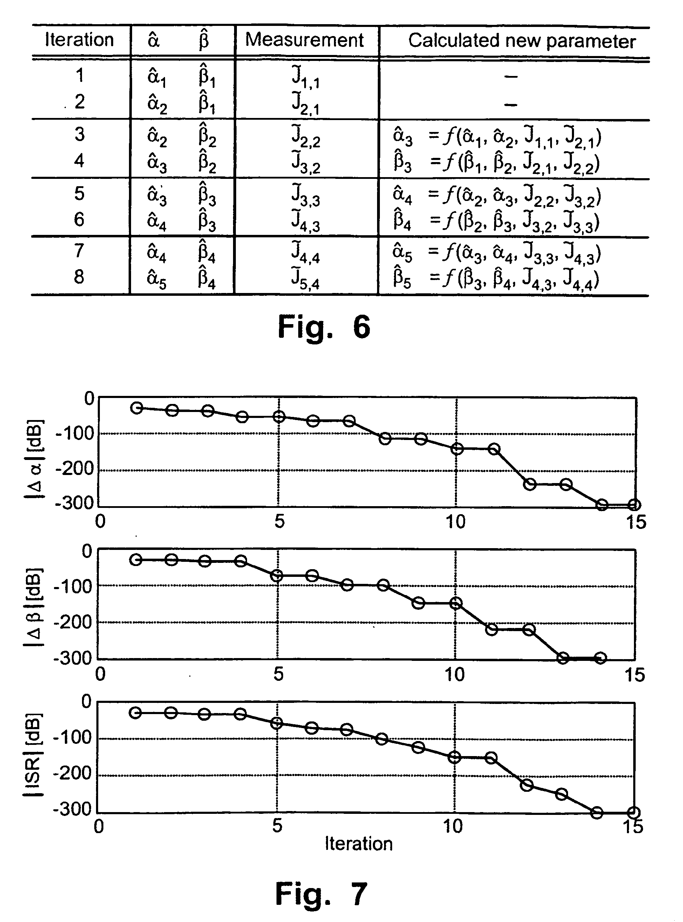

The first eight iterations of the proposed adaptive estimation and compensation algorithm are shown in Figure 6. For ease of explanation the shortened notation $\tilde{J}_{n,m} = \tilde{J}(\hat{\alpha}_n, \hat{\beta}_m)$ and the formal function

$$(15)$$

$$f(p_1, p_2, \tilde{J}_1, \tilde{J}_2) = \frac{1}{2}\left[p_1 + p_2 - \frac{\tilde{J}_1 - \tilde{J}_2}{p_1 - p_2}\right]$$

are used in the following. The adaptation has to be initialized with two parameter pairs $\hat{\alpha}_1 \neq \hat{\alpha}_2, \hat{\beta}_1 \neq \hat{\beta}_2$. It is reasonable to choose values, which are in the order of the expected numbers, e.g.

$$\hat{\alpha}_1 = 0.99 \qquad \hat{\beta}_1 = -0.01$$

$$\hat{\alpha}_2 = 1.01 \qquad \hat{\beta}_2 = +0.01$$

These initialization values are used in the following simulations. In the first iteration the digital pre-distortion is configured with the parameters $\hat{\alpha}_1$ and $\hat{\beta}_1$. Based on the resulting *ISR* the approximated cost function $\tilde{J}_{1,1}$ can be determined using (14). This scheme based on a systematic configuration of the pre-distortion followed by an observation of the resulting ISR is repeated with a continuous update of the parameter estimates. In every even iteration a new setting $\hat{\alpha}$ is chosen, whereas in every odd iteration a new setting $\hat{\beta}$ is chosen. This strategy allows for an alternating update of one of the two parameters to be estimated, leading to a joint optimization of the whole digital pre-distortion block.

The convergence properties of the proposed adaptation algorithm were studied using MATLAB. In order to understand its fundamental properties, a perfect measurement of the resulting *ISR* was assumed. The influence of measurement errors in a real system will be addressed in the next section. For now, the *ISR* is determined analytically using (8).

A typical plot of the adaptation is shown in Fig. 7. Both the estimation errors and the measured ISR are shown in dB-scale:

$$\left|\Delta\alpha\right|_{dB} = 20\log_{10}\left|\hat{\alpha} - \alpha\right|$$

$$\left|\Delta\beta\right|_{dB} = 20\log_{10}\left|\hat{\beta} - \beta\right|$$

$$ISR_{dB} = 10\log_{10}ISR$$

Clearly the alternating reconfiguration of the estimated parameters, as well as the rapid convergence to the real I/Q imbalance parameters can be seen. In the course of the adaptation of the estimated compensation parameters the resulting *ISR* reaches arbitrarily low values. After less than 10 iterations the power ratio drops below -100 dB, which is sufficient for most practical applications.

The course of the adaptation shown in Fig. 7 is valid only for the exemplary I/Q imbalance parameters $g$ = 1.02 and $\phi = 2°$. In order to prove the suitability of the proposed algorithm for arbitrary I/Q imbalance parameters, its performance was evaluated using Monte-Carlo simulations. At the beginning of each realization new I/Q imbalance parameters were randomly chosen by modelling the gain imbalance $g$ and the phase imbalance $\phi$ as independent Gaussian distributed random variables. In order to simulate practical relevant values, $g$ was assumed to have a mean of 1 and a standard deviation of 2%, whereas $\phi$ was assumed to have a mean of 0 and a standard deviation of 2°.

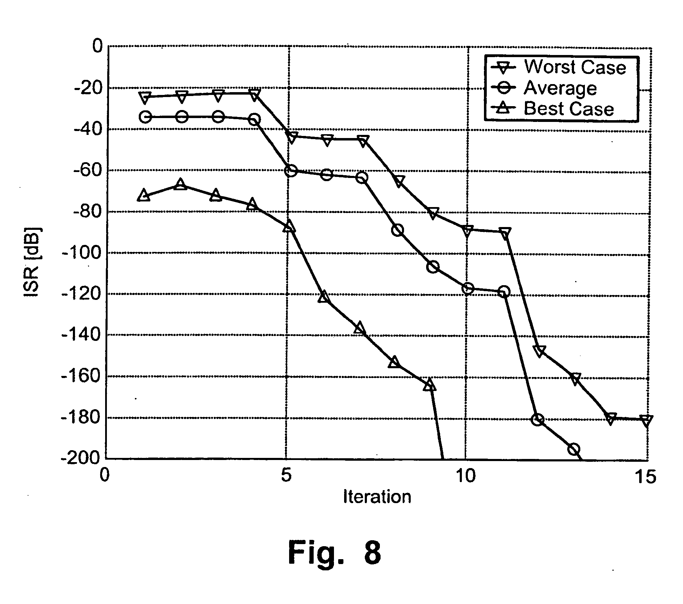

The result after 10.000 independent realizations is shown in Fig. 8. For each iteration the minimum, the maximum and the average *ISR* of all realizations is plotted. It can be seen, that the maximum (worst case) plot shows slightly higher ISR values than the exemplary plot in Fig. 7. This effect is a result of higher initial estimation errors in the case of a highly imbalanced analog mixer ($|g-1|$ > 5%, $|\phi|$ > 5°). However, the important result is, that the general properties of fast and global convergence are maintained even for arbitrary real I/Q imbalance parameters.

It should be stressed, that the results presented so far are valid only under the assumption of a perfectly measured *ISR*. They represent the limit of what is achievable under ideal conditions. Therefore they provide a useful reference for evaluating the performance degradations due to impacts of a practical realization.

In a practical system a perfect measurement of the *ISR* is not achievable. Instead, measuring the power of the desired signal and the image signal in the RF signal $r(t)$ results in the estimates $\hat{P}_i$ and $\hat{P}_s$. Now the resulting approximated cost function

$$
\hat{J}(\hat{\alpha}, \hat{\beta}) = 4\hat{\alpha}^2 \, \frac{\hat{P}_i(\hat{\alpha}, \hat{\beta})}{\hat{P}_s(\hat{\alpha}, \hat{\beta})},
$$

(16)

has an additional deviation from the true cost function $J(\hat{\alpha}, \hat{\beta})$ due to an imperfectly measured *ISR.* The impact of this additional deviation strongly depends on the characteristics of the power measurements and hence on the realization of the feedback path from the RF part of the transmitter.

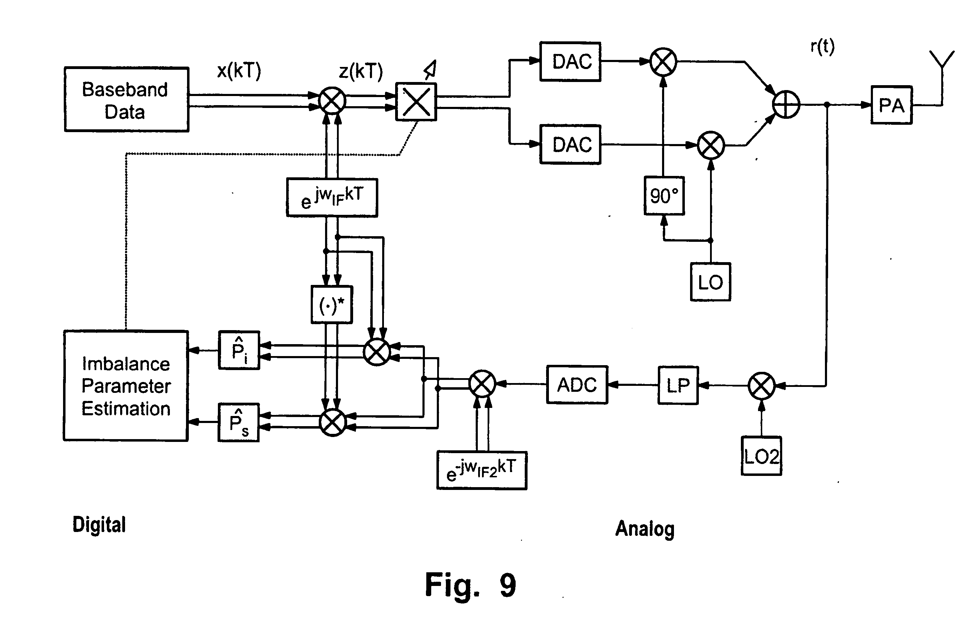

For example we consider one possibility for realizing such a feedback, which is based on a heterodyne receiver architecture (Fig. 9). Here the frequency of the analog down-mixing LO $\omega_{LO2}$ and the frequency of the additional digital LO $\omega_{IF2}$ are adjusted to the frequency of the transmit-LO, such that $\omega_{LO} = \omega_{LO2} + \omega_{IF2}$. The power estimates $\hat{P}_s$ and $\hat{P}_i$ can be measured using time averages of the corresponding baseband signals.

The simultaneous measurement of $\hat{P}_i$ and $\hat{P}_s$ ensures robustness in the case of a time-varying transmit power $P_x$. However, one of the drawbacks is, that the (high power) desired signal and the (low power) image signal are digitized simultaneously with the same A/D converter. Hence, the accuracy of $\hat{P}_i$, and consequently of $\hat{J}(\hat{\alpha}, \hat{\beta})$, will be limited by the resolution of the A/D converter.

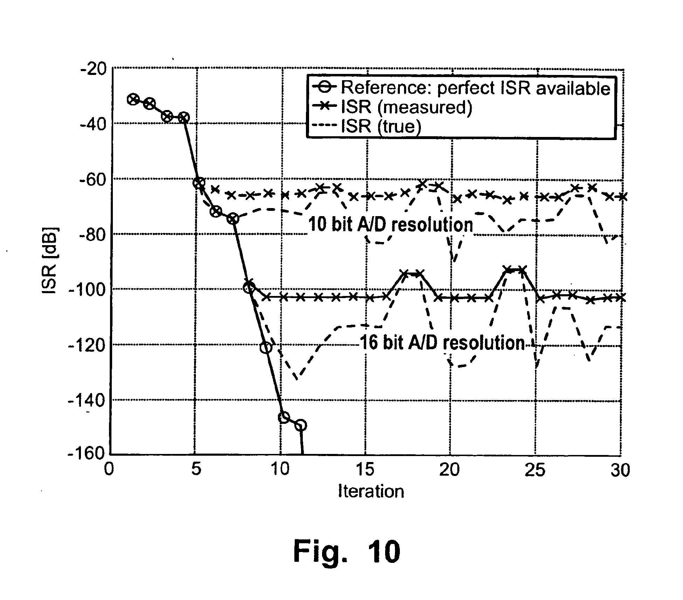

This effect is illustrated in Fig. 10. For the same I/Q imbalance parameters ($g$ =1.02, $\phi$ = 2˚) the course of the adaptation is compared for a perfect *ISR* measurement with an imperfect *ISR* measurement. As source of the imperfection we consider the A/D converter, which is modelled as a linear quantizer with a fixed range and a variable number of quantization bits. 10 bit resolution and 16 bit resolution are chosen in Fig. 10 for example.

It can be seen, that for the first iterations (high *SIR*) the courses of the individual adaptations are identical. Here the systematic displacement of $\tilde{J}$ from $J$ is dominating, the additional displacement of $\tilde{J}$ is negligible. In contrast, the individual adaptations deviate, if the *ISR* reaches a certain small value. Depending on the A/D resolution the *measured ISR* never falls below a specific limit, despite the *true ISR* (calculated for comparison based on (8)) is much lower. This is because even for a perfectly rejected image, the frequency band evaluated for measuring the image power will be superimposed by the quantization noise. Obviously, the residual noise power and therefore the measurable *ISR* can be decreased by increasing the resolution of the A/D converter.

As a consequence of the imperfect power measurements, the parameter estimates do not converge arbitrarily close to the desired numbers. Instead, for small *ISR* values the adaptation shows a random behavior. This is not critical, if the algorithm is used for an initial calibration of the transmitter only. In this case the adaptation can be stopped when a predefined target *ISR,* depending on the RF requirements of the chosen communications standard, is reached. However the algorithm can also be used for continuous adaptation, for example in order to track a time-variant I/Q imbalance.

In accordance with the adaptive algorithm for the digital compensation of analog I/Q imbalance in Digital-IF transmitter architectures of the invention the adaptation of the digital pre-distortion block is performed during regular transmission mode without the need for any special calibration or training signal. Simulations have shown the rapid and reliable convergence of the estimated compensation parameters for arbitrary realistic I/Q imbalances.

The theoretically arbitrary high accuracy will be limited in practice due to imperfect power measurements. However, studies on an exemplary design showed, that an image suppression of more than 60 dB can be easily reached. Since this value is sufficient to fulfill the RF requirements of most communications standards, an application of the proposed algorithm is highly attractive.

The present invention is particularly advantageous as the adaptation of the pre-distortion parameters can be performed blindly during regular transmission mode. With the proposed novel adaptation algorithm no special training or calibration signal is required.

**Claims**

1.   A transmitter comprising:

- means (104) for generating an intermediate frequency signal,
- means (106) for predistortion of the intermediate frequency signal using a predistortion parameter,
- means (112, 114, 116) for generating a radio frequency signal from the predistorted intermediate frequency signal,
- means (124) for determining an image-to-signal-ratio of the radio frequency signal,
- means (126) for adaptation of the predistortion parameter for reduction of the image-to-signal-ratio, wherein said means (126) is adapted to perform the adaptation of the predistortion parameter during a regular transmission mode using the regular transmit signal only.

2. The transmitter of claim 1, the means for adaptation of the predistortion parameter being operable to perform an iterative algorithm for adaptation of the predistortion parameters.

3. The transmitter of claim 1, the means for adaptation of the predistortion parameter being operable to use a cost function to perform the adaptation.

4. A transmission method comprising:

    - generating an intermediate frequency signal,
    - predistortion of the intermediate frequency signal using a predistortion parameter,
    - generating a radio frequency signal from the predistorted intermediate frequency signal,
    - obtaining an image-to-signal-ratio of the radio frequency signal,
    - adaptation of the predistortion parameter for reduction of the image-to-signal-ratio, wherein the adaptation of the predistortion parameter is performed during a regular transmission mode using the regular transmit signal only.

5. The transmission method of claim 4, further comprising performing an iterative algorithm for adaptation of the predistortion parameter.

6. The transmission method of claim 4, further comprising using a cost function to perform the adaptation of the predistortion parameter.

7. The transmission method of claim 4, further comprising using a heterodyne receiver based feedback loop for estimating the power of a desired signal component of the radio frequency signal and the image component of the radio frequency signal.

8. The transmission method of claim 4, further comprising comparing the current image-to-signal-ratio with a threshold level in order to determine whether further adaptation of the predistortion parameter is required or not.

9. A computer program product, in particular digital storage medium, adapted to perform the transmission method of claim 4.

10. A telecommunication device, such as a base station or a mobile terminal, for use in a digital telecommunication network, the telecommunication device comprising a transmitter in accordance with claim 1.

**Patentansprüche**

1. Ein Sender, der Folgendes umfasst:

    - Mittel (104)zur Erzeugung eines Zwischenfrequenzsignals,
    - Mittel (106) zur Vorverzerrung des Zwischenfrequenzsignals unter Verwendung eines Vorverzerrungs-Parameters,
    - Mittel (112, 114, 116) zur Erzeugung eines Hochfrequenzsignals aus dem vorverzerrten Zwischenfrequenzsignal,
    - Mittel (124) zur Ermittlung eines Bild/Signal-Verhältnisses des Hochfrequenzsignals,
    - Mittel (126) zur Anpassung des Vorverzerrungsparameters zur Verringerung des Bild/Signal-Verhältnisses, wobei die genannten Mittel (126) in der Lage sind, die Anpassung des Vorverzerrungsparameters im Verlauf des regulären Sendemodus durchzuführen, wobei nur das reguläre Sendesignal genutzt wird.

2. Der Sender gemäß Anspruch 1, wobei die Mittel zur Anpassung des Vorverzerrungsparameters in der Lage sind, einen iterativen Algorithmus zur Anpassung der Vorverzerrungsparameter auszuführen.

**3.** Der Sender gemäß Anspruch 1, wobei die Mittel zur Anpassung des Vorverzerrungsparameters in der Lage sind, eine Kostenfunktion zur Durchführung der Anpassung einzusetzen.

**4.** Ein Sendeverfahren, das Folgendes umfasst:

- Erzeugung eines Zwischenfrequenzsignals,
- Vorverzerrung des Zwischenfrequenzsignals mit Hilfe eines Vorverzerrungsparameters,
- Erzeugung eines Hochfrequenzsignals aus dem vorverzerrten Zwischenfrequenzsignal.
- Ermittlung eines Bild/Signal-Verhältnisses des Hochfrequenzsignals,
- Anpassung des Vorverzerrungsparameters zur Verringerung des Bild/Signal-Verhältnisses, wobei die Anpassung des Vorverzerrungsparameters im Verlauf eines regulären Sendemodus durchgeführt und nur das reguläre Sendesignal eingesetzt wird.

**5.** Das Sendeverfahren gemäß Anspruch 4, das außerdem die Ausführung eines iterativen Algorithmus zur Anpassung des Vorverzerrungsparameters umfasst.

**6.** Das Sendeverfahren gemäß Anspruch 4, das außerdem den Einsatz einer Kostenfunktion zur Umsetzung der Anpassung des Vorverzerrungsparameters umfasst.

**7.** Das Sendeverfahren gemäß Anspruch 4, das außerdem den Einsatz einer Interferenzen erzeugenden, Empfänger-basierten Rückkopplungsschleife zur Schätzung der Leistung einer gewünschten Signalkomponente des Hochfrequenzsignals und der Spiegelkomponente des Hochfrequenzsignals umfasst.

**8.** Das Sendeverfahren gemäß Anspruch 4, das außerdem einen Vergleich des aktuellen Bild/Signal-Verhältnisses mit einem Grenzwert umfasst, um zu ermitteln, ob eine weitere Anpassung des Vorverzerrungsparameters erforderlich ist oder nicht.

**9.** Ein Computerprogramm-Produkt, insbesondere ein digitales Speichermedium, das in der Lage ist, das Sendeverfahren gemäß Anspruch 4 auszuführen.

**10.** Ein Telekommunikationsgerät, wie beispielsweise eine Basisstation oder ein mobiles Endgerät, zum Einsatz in einem digitalen Telekommunikationsnetz, wobei das Telekommunikationsgerät einen Sender gemäß Anspruch 1 umfasst.

**Revendications**

**1.** Émetteur comprenant :

- des moyens (104) pour générer un signal de fréquence intermédiaire,
- des moyens (106) de pré-distorsion du signal de fréquence intermédiaire en utilisant un paramètre de pré-distorsion,
- des moyens (112, 114, 116) pour générer un signal à haute fréquence à partir du signal de fréquence intermédiaire ayant subi la pré-distorsion,
- des moyens (124) pour déterminer un rapport image/signal du signal à haute fréquence,
- des moyens (126) pour l'adaptation du paramètre de pré-distorsion en vue de réduire le rapport image/signal, lesdits moyens (126) étant conçus pour effectuer l'adaptation du paramètre de pré-distorsion pendant un mode de transmission normal en utilisant uniquement le signal émis normal.

**2.** Émetteur selon la revendication 1, les moyens d'adaptation du paramètre de pré-distorsion pouvant être utilisés de manière à exécuter un algorithme itératif en vue de l'adaptation des paramètres de pré-distorsion.

**3.** Émetteur selon la revendication 1, les moyens d'adaptation du paramètre de pré-distorsion pouvant être utilisés de manière à utiliser une fonction de charge dans l'adaptation.

**4.** Procédé d'émission comprenant :

- la génération d'un signal de fréquence intermédiaire,

- la pré-distorsion du signal de fréquence intermédiaire en utilisant un paramètre de pré-distorsion,
- la génération d'un signal à haute fréquence à partir du signal de fréquence intermédiaire ayant subi la pré-distorsion,
- l'obtention d'un rapport image/signal du signal à haute fréquence,
- l'adaptation du paramètre de pré-distorsion en vue de réduire le rapport image/signal, l'adaptation du paramètre de pré-distorsion étant effectuée pendant un mode de transmission normal en utilisant uniquement le signal émis normal.

5. Procédé d'émission selon la revendication 4, comprenant en plus l'exécution d'un algorithme itératif en vue de l'adaptation du paramètre de pré-distorsion.

6. Procédé d'émission selon la revendication 4, comprenant en plus l'utilisation d'une fonction de charge en vue de l'adaptation du paramètre de pré-distorsion.

7. Procédé d'émission selon la revendication 4, comprenant en plus l'utilisation d'une boucle de contre-réaction basée sur un récepteur hétérodyne pour estimer la puissance d'une composante de signal voulue du signal à haute fréquence et de la composante image du signal à haute fréquence.

8. Procédé d'émission selon la revendication 4, comprenant en plus la comparaison du rapport image/signal actuel avec un niveau de seuil afin de déterminer si une adaptation supplémentaire du paramètre de pré-distorsion est nécessaire ou non.

9. Programme informatique, notamment support de stockage numérique, conçu pour mettre en oeuvre le procédé d'émission selon la revendication 4.

10. Dispositif de télécommunication tel qu'une station de base ou un terminal mobile destiné à être utilisé dans un réseau de télécommunication numérique, le dispositif de télécommunication comprenant un émetteur selon la revendication 1.

**Fig. 1**

EP 1 641 132 B1

**Fig. 2**

EP 1 641 132 B1

**300** Baseband Signal x

**302** Digital I/Q mixing $\Longrightarrow z_I, z_Q$(IF Signal)

**304** Predistortion of IF Signal using Predistortion Parameters

**306** Multiplication with analogue oscillator $\Longrightarrow r$(RF Signal)

**310** Measurement ISR

**312** Adaptation of Predistortion Parameters for reduction of ISR

**308** Power amplification

**Fig. 3**

**Fig. 4**

**Fig. 5**

| Iteration | $\hat{\alpha}$ | $\hat{\beta}$ | Measurement | Calculated new parameter |
|---|---|---|---|---|
| 1 | $\hat{\alpha}_1$ | $\hat{\beta}_1$ | $\mathfrak{J}_{1,1}$ | — |
| 2 | $\hat{\alpha}_2$ | $\hat{\beta}_1$ | $\mathfrak{J}_{2,1}$ | — |
| 3 | $\hat{\alpha}_2$ | $\hat{\beta}_2$ | $\mathfrak{J}_{2,2}$ | $\hat{\alpha}_3 = f(\hat{\alpha}_1, \hat{\alpha}_2, \mathfrak{J}_{1,1}, \mathfrak{J}_{2,1})$ |
| 4 | $\hat{\alpha}_3$ | $\hat{\beta}_2$ | $\mathfrak{J}_{3,2}$ | $\hat{\beta}_3 = f(\hat{\beta}_1, \hat{\beta}_2, \mathfrak{J}_{2,1}, \mathfrak{J}_{2,2})$ |
| 5 | $\hat{\alpha}_3$ | $\hat{\beta}_3$ | $\mathfrak{J}_{3,3}$ | $\hat{\alpha}_4 = f(\hat{\alpha}_2, \hat{\alpha}_3, \mathfrak{J}_{2,2}, \mathfrak{J}_{3,2})$ |
| 6 | $\hat{\alpha}_4$ | $\hat{\beta}_3$ | $\mathfrak{J}_{4,3}$ | $\hat{\beta}_4 = f(\hat{\beta}_2, \hat{\beta}_3, \mathfrak{J}_{3,2}, \mathfrak{J}_{3,3})$ |
| 7 | $\hat{\alpha}_4$ | $\hat{\beta}_4$ | $\mathfrak{J}_{4,4}$ | $\hat{\alpha}_5 = f(\hat{\alpha}_3, \hat{\alpha}_4, \mathfrak{J}_{3,3}, \mathfrak{J}_{4,3})$ |
| 8 | $\hat{\alpha}_5$ | $\hat{\beta}_4$ | $\mathfrak{J}_{5,4}$ | $\hat{\beta}_5 = f(\hat{\beta}_3, \hat{\beta}_4, \mathfrak{J}_{4,3}, \mathfrak{J}_{4,4})$ |

# Fig. 6

# Fig. 7

**Fig. 8**

Fig. 9

**Fig. 10**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03043206 A2

**Non-patent literature cited in the description**

- **M. WINDISCH ; G. FETTWEIS.** Blind I/Q Imbalance Parameter Estimation and Compensation in Low-IF Receivers. *Proceedings of the 1st International Symposium on Control, Communications and Signal Processing,* 21 March 2004
- **L. BRÖTJE ; S. VOGELER ; K.-D. KAMMEYER.** Estimation and Correction of transmitter-caused I/Q Imbalance in OFDM Systems. *Proceedings of the 7th International OFDM-Workshop,* 10 September 2002
- **X. HUANG.** On Transmitter Gain/Phase Imbalance Compensation At Receiver. *IEEE Communications Letters,* vol. 4, 363-365
- **J. K. CAVERS ; M. W. LIAO.** Adaptive Compensation for Imbalance and Offset Losses in Direct Conversion Transceivers. *IEEE Transactions on Vehicular Technology,* November 1993, vol. 42, 581-588
- **X. HUANG ; M. CARON.** Gain/phase imbalance and DC offset compensation in quadrature modulators. *IEEE International Symposium on Circuits and Systems 2002,* 26 May 2002, vol. 4, IV-811-IV-814